Europäisches Patentamt

European Patent Office

Office européen des brevets

(19)

(11) Veröffentlichungsnummer: **0 312 631**

**A1**

(12) # EUROPÄISCHE PATENTANMELDUNG

(21) Anmeldenummer: 87115411.8

(22) Anmeldetag: 21.10.87

(51) Int. Cl.⁴: **H05K 3/36 , H05K 7/06 , H05K 1/18**

(43) Veröffentlichungstag der Anmeldung:
26.04.89 Patentblatt 89/17

(84) Benannte Vertragsstaaten:
AT BE CH DE ES FR GB GR IT LI LU NL SE

(71) Anmelder: PRESSKONTAKT Ing. grad.
Hartmuth Thaler KG
Zeilbaumweg 15
D-7110 Oehringen(DE)

(72) Erfinder: Thaler, Hartmuth F., Ing. (grad)
Hohe Strasse 15
D-7110 Oehringen(DE)
Erfinder: Mueller, Ulrich H.A., Dipl.-Phys. Ing.
Alemannenstr. 21
D-7110 Retzfeld-Bitzfeld(DE)

(74) Vertreter: Charrier, Rolf, Dipl.-Ing.
Postfach 260 Rehlingenstrasse 8
D-8900 Augsburg 31(DE)

(54) Verfahren zur Herstellung elektrischer Verbindungen zwischen flachen elektrischen Leiterbahnen und danach hergestellte Leiterplatten.

(57) Zum Herstellen elektrisch leitender Verbindungen zwischen flachen Leiterbahnen (3, 4), die durch einen Isolierträger voneinander getrennt sind, werden zwei Metallfolien (1, 2), die mit Heißkleberschichten (5, 6) beschichtet sind, nebeneinandergelegt. An den Stellen der später herzustellenden und miteinander zu verbindenden Leiterbahnen (3, 4) sind Kontaktpunkte (7, 10) vorgesehen, an welche Drähte (8, 9, 10) angeschweißt werden, die, soweit sie auf der Ebene der Metallfolien (1, 2) verlaufen, durch Wärmezufuhr in die Schichten (5, 6) eingebettet werden. Anschließend werden die Metallfolien (1, 2) mit ihren Heißkleberschichten (5, 6) unter Zwischenlage des Isolierträgers gegeneinandergeklappt und durch Wärmezufuhr mit diesem verbunden. Nunmehr werden von den Metallfolien (1, 2) die Zwischenräume (13, 14) zur Bildung der Leiterbahnen (3, 4) abgeätzt.

Fig.1

Die Erfindung betrifft Verfahren zur Herstellung elektrischer Verbindungen zwischen flachen elektrischen Leiterbahnen nach den Oberbegriffen der Ansprüche 1 und 2 sowie Schaltungsplatten mit flachen elektrischen Leiterbahnen, welche elektrisch miteinander verbunden sind.

Bei einer Schaltungsplatte, welche aus einem Isolierträger und darauf angeordneten flachen elektrischen Leiterbahnen besteht, ist es oftmals erforderlich, die elektrischen Leiterbahnen miteinander zu verbinden. Hierbei ist es bekannt, elektrisch isolierte Drähte zu verwenden, welche mit ihren Enden an Kontaktpunkten der miteinander zu verbindenden Leiterbahnen verlötet oder verschweißt werden. Diese Drähte verlaufen üblicherweise bogenförmig vom einen zum anderen Kontaktpunkt. Die von den Drähten eingenommene Höhe beträgt ein Mehrfaches der Dicke der Schaltungsplatte. Es ist auch bekannt, die Leiterbahnen von nebeneinanderliegenden Schaltungsplatten auf diese Weise miteinander zu verbinden.

Weist eine Schaltungsplatte an beiden Seiten Leiterbahnen auf, welche miteinander verbunden werden sollen, dann werden Teile der miteinander zu verbindenden Leiterbahnen so geführt, daß sie einander überdecken. An diesen überdeckungsbereichen wird eine Bohrung erzeugt, über die eine metallische Verbindung von der einen Leiterbahnebene zur anderen Leiterbahnebene hergestellt wird. Sollen die Leiterbahnen von mindestens zwei übereinander angeordneten Schaltungsplatten miteinander verbunden werden, dann werden ebenfalls Teile der miteinander zu verbindenden Leiterbahnen so geführt, daß sie einander überdecken, wobei an den Überdeckungsstellen jeweils Bohrungen in die Schaltungsplatten eingebracht werden. Diese Bohrungen werden metallisiert und durch Metallstifte miteinander verbunden. Dieses Verfahren ist kostspielig.

Es besteht die Aufgabe, elektrische Verbindungen zwischen flachen elektrischen Leiterbahnen auf einfache Weise herzustellen, wobei die Verbindungen wenig Raum beanspruchen und zahlreiche Verbindungen auf geringstem Raum ermöglichen sollen.

Gelöst wird diese Aufgabe durch Verfahren nach den Ansprüchen 1 und 2, wobei vorteilhafte Ausgestaltungen in den Unteransprüchen angegeben sind sowie durch Schaltungsplatten nach den Ansprüchen 12 bis 14.

Ein Herstellverfahren wird nachfolgend anhand der Zeichnungen näher erläutert. Es zeigen:

Fig. 1 eine perspektivische Ansicht der beiden nebeneinanderliegenden Metallschichten mit den die später zu bildenden Leiterbahnen verbindenden Drähten zur Erläuterung eines ersten Verfahrensschritts;

Fig. 2 eine Seitenansicht der Darstellung nach Fig. 1;

Fig. 3 eine der Fig. 2 entsprechende Seitenansicht zur Darstellung eines weiteren Verfahrensschritts;

Fig. 4 einen Schnitt durch ein erstes Ausführungsbeispiel einer Schaltungsplatte;

Fig. 5 einen Schnitt durch eine zweite Ausführungsform einer Schaltungsplatte;

Fig. 6 einen Schnitt durch eine dritte Ausführungsform einer Schaltungsplatte;

Fig. 7 eine schematische Darstellung zur Erläuterung der Verbindung zweier Schaltungsplatten nach Fig. 4 oder 5 und

Fig. 8 eine schematische Darstellung zur Erläuterung einer mehrere Ebenen aufweisenden Schaltungsplatte.

Das nachfolgend erläuterte Ausführungsbeispiel dient zur Herstellung einer Schaltungsplatte, welche aus einem Isolierträger und beidseits auf dem Isolierträger aufgebrachten Leiterbahnen besteht, wobei Leiterbahnen der einen Leiterbahnebene, Leiterbahnen der anderen Leiterbahnebene und Leiterbahnen beider Leiterbahnebenen miteinander verbunden sind.

Als erster Verfahrensschritt werden zwei Metallfolien 1, 2 nebeneinandergelegt. Bei diesen Metallfolien handelt es sich bevorzugt um Kupferfolien. Die später aus diesen Metallfolien herzustellenden Leiterbahnen sind bei der Metallfolie 1 mit 3 und bei der Metallfolie 2 mit 4 bezeichnet. Diese später herzustellenden Leiterbahnen 3, 4 sind gestrichelt dargestellt.

Jede Metallfolie 1, 2 weist eine Isolierschicht 5, 6 auf, wobei es sich bei den Isolierschichten 5, 6 um Heißkleberschichten handelt.

Soll die später zu erzeugende Leiterbahn 4a mit der Leiterbahn 4b verbunden werden, dann werden bei der Isolierschicht 6 Kontaktpunkte 7a, 7b freigelassen. Diese Freistellen in der Isolierschicht 6 können bereits beim Aufbringen der Isolierschicht 6 auf die Metallfolie 2 vorgesehen werden oder die Isolierschicht 6 wird an diesen Stellen 7a, 7b nachträglich entfernt.

Ein an seinem einen Ende blanker Isolierdraht 8 wird am Kontaktpunkt 7a mit der Folie 2 verbunden, was durch Löten, bevorzugt jedoch durch Anschweißen erfolgt. Dieser Draht 8 wird sodann unter Wärmezufuhr zum Kontaktpunkt 7b geführt, wobei er in die Isolierschicht 6 eingebettet wird und bei Erreichen des Kontaktpunktes 7b dort mit der Metallfolie 2 verbunden wird, entsprechend der Verbindung beim Kontaktpunkt 7a. Auf diese Weise sind die später herzustellenden Leiterbahnen 4a und 4b elektrisch miteinander verbunden.

In entsprechender Weise wird bei der Metallfolie 1 vorgegangen, wo der Draht 9 mit den Kontaktpunkten 10a und 10b verbunden wird, was wie vorbeschrieben durch Löten, bevorzugt jedoch durch Schweißen erfolgt. Zwischen den Kontaktpunkten 10a und 10b ist der Draht 8 in die Isolierschicht 5 eingebettet. Auf diese Weise sind die später herzustellenden Leiterbahnen 3a und 3b elektrisch miteinander verbunden.

Weiterhin soll die später herzustellende Leiterbahn 3c mit der später herzustellenden Leiterbahn 4c verbunden werden. Zu diesem Zweck ist bei der Metallfolie 1 der von der Isolierschicht 5 freie Kontaktpunkt 10c vorgesehen, während bei der Folie 2 dies der Kontaktpunkt 7c ist. Am Kontaktpunkt 7c wird das eine Ende des Isolierdrahtes 11 befestigt, der unter Wärmezufuhr zur rechten Kante der Metallfolie 2 geführt wird, wobei er in die Isolierschicht 6 eingebettet wird. Er wird sodann frei zur linken Kante der Folie 2 geführt und von dort unter Wärmezufuhr zur Kontaktstelle 10c. Er wird sodann an dieser Kontaktstelle mit der Metallfolie 1 verbunden.

Hierbei ist es jederzeit möglich, daß sich Drähte 8, 9, 11 überkreuzen.

In der vorbeschriebenen Weise können weitere Kontaktpunkte 7 untereinander, weitere Kontaktpunkte 10 unter einander und weitere Kontaktpunkte 7 und 10 miteinander verbunden werden, welche jeweils den später noch herzustellenden Leiterbahnen 3, 4 zugeordnet sind.

Auf diese Weise verlaufen alle Drähte 8, 9 auf der Ebene der Metallfolien 2, 1 und sind jeweils in die aus einem Heißkleber bestehenden Isolierschichten 6, 5 eingebettet. Dies gilt auch für diejenigen Teile der Drähte 11, die auf der Ebene der Metallfolien 1, 2 verlaufen. Zwischen den Metallfolien verlaufen diese Drähte frei.

Die Verlegung der Drähte 8, 9, 11,die Freilegung der Drahtenden von der Drahtisolierung, das Befestigen dieser Drähte an den Kontaktstellen 7, 10 und das Abstechen der Drähte erfolgt automatisch mit Hilfe eines sogenannten Multiwire-Automaten.

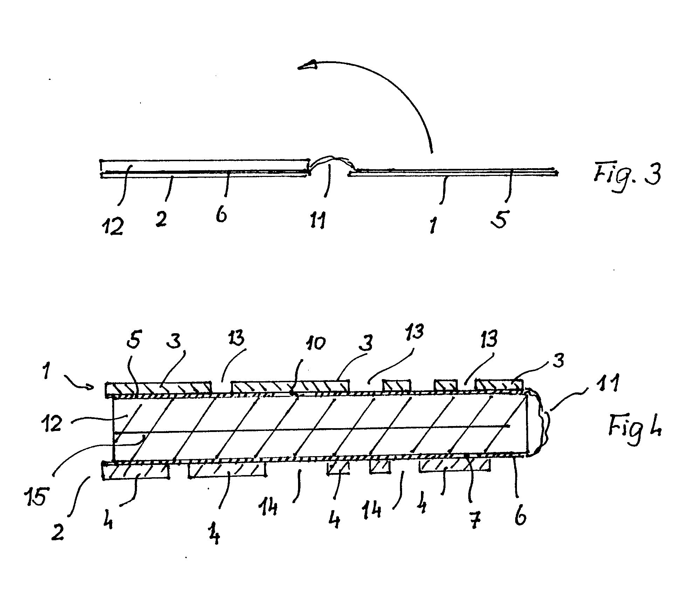

Die beiden Metallfolien 1, 2 werden nunmehr, wie dies die Fig. 3 zeigt, mit ihren die Isolierschichten aufweisenden Seiten 5, 6 gegeneinander geklappt und zwar unter Zwischenlage eines Isolierträgers. Dieser Isolierträger 12 wird sodann im zusammengeklappten Zustand unter Wärmezufuhr über die aus einem Isolierkleber bestehenden Schichten 5, 6 mit den Metallfolien 1, 2 verklebt. Die Teile der Drähte 11, welche zwischen den Folien 1, 2 verlaufen, können hierbei den Isolierträger 12 halbkreisförmig umschlingen.

Nunmehr werden die beiden Metallfolien 1, 2 in üblicher Weise zur Herstellung der Leiterbahnen 3, 4 behandelt. Dies erfolgt durch Abätzen der Zwischenräume 13 bei der Metallfolie 1 und durch Abätzen der Zwischenräume 14 bei der Metallfolie 2, so daß auf beiden Seiten des Isolierträgers 12 die Leiterbahnen 3, 4 verbleiben, die in vorbeschriebener Weise über die Drähte 8, 9, 11 elektrisch miteinander verbunden sind.

Bei der Verbindung der Drähte 8, 9, 11 mit den Folien 1, 2 an den Kontaktpunkten 7, 10 ist es gleichzeitig möglich, die Güte der elektrischen Verbindung durch Anlegen einer elektrischen Spannung zwischen dem verlegten Draht und der kontaktierten Metallfolie zu messen.

Anstelle des Vorsehens der aus einem Heißkleber bestehenden Isolierschichten 5, 6 ist es auch möglich, die Isolierung der Drähte 8, 9, 11 aus einem Isolierkleber herzustellen oder mit einem Schmelzkleber zu beschichten, so daß dann die Drähte durch Wärmezufuhr direkt auf der Oberfläche der Metallfolien 1, 2 haften. Der Isolierträger 12 besteht dann bevorzugt aus einem solchen Material, in welches die Drähte eingebettet werden, was bevorzugt durch Wärmezufuhr erfolgt, wenn die Metallfolien 1, 2 unter Zwischenlage des Isolierträgers 12 gegeneinander geklappt sind.

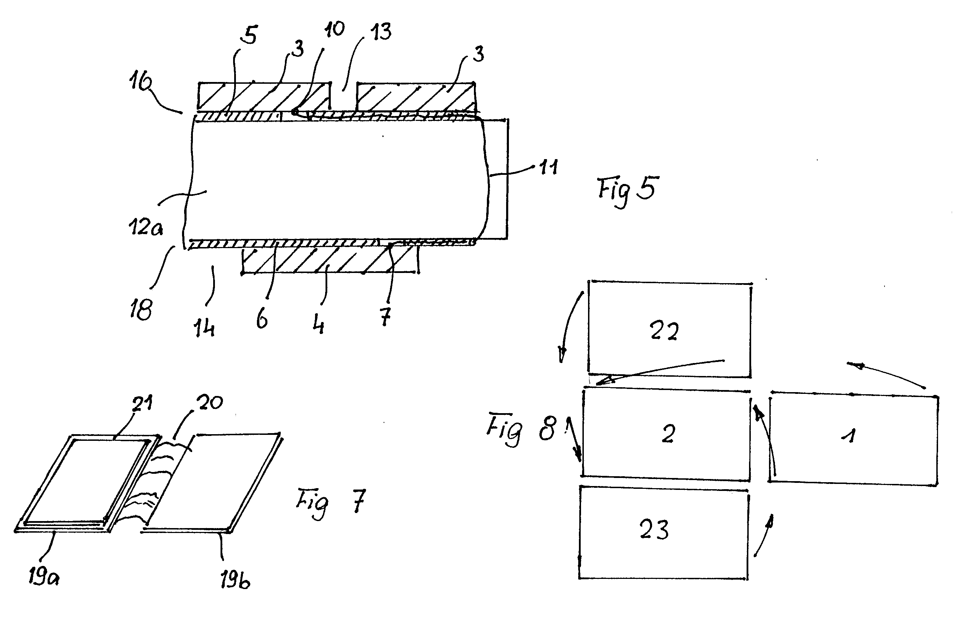

Der Isolierträger 12 kann eine Abschirmschicht 15 aufweisen, wie dies die Figuren 4 und 5 zeigen. Durch eine derartige Abschirmschicht 15 werden die Leiterbahnen 3, 4 hochfrequent gegeneinander abgeschirmt.

Gemäß Fig. 5 besteht der Isolierträger 12a aus einem Kunststoff, der beim Zusammenklappen der beiden Metallfolien 1, 2 noch nicht durchgehärtet ist, so daß die Teile der Drähte 11, welche frei zwischen den Metallfolien 1, 2 verlaufen, in diesen eindringen und somit vom Isolierträger 12a umschlossen werden. Bei der anschließenden Wärmezufuhr härtet dann dieser Isolierträger aus. Anschließend werden in vorbeschriebener Weise durch Abätzen der Zwischenräume 13, 14 die Leiterbahnen 3, 4 aus den Metallfolien 1, 2 erzeugt.

Ist eine Schaltungsplatte auf diese Weise erzeugt worden, dann weist sie eine obere Verdrahtungsebene 16 unterhalb der Leiterbahnen 3 und eine zweite Verdrahtungsebene 18 oberhalb der Leiterbahnen 4 auf.

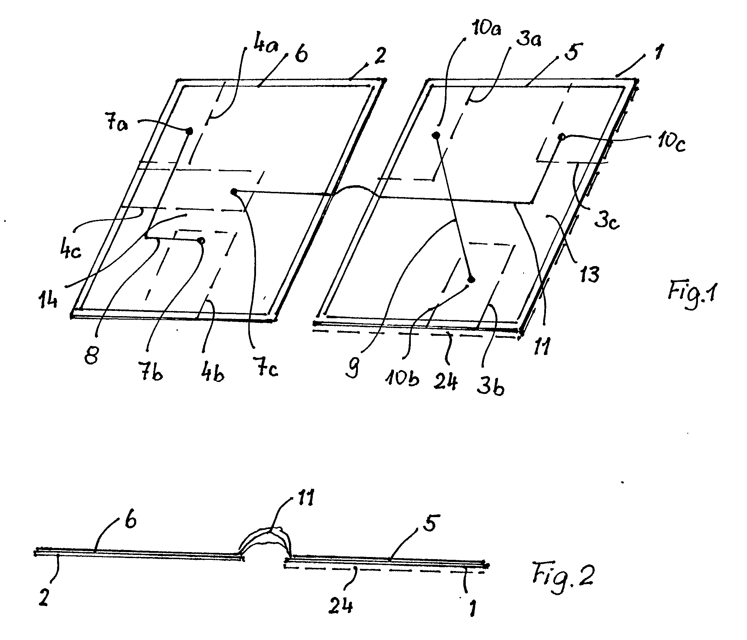

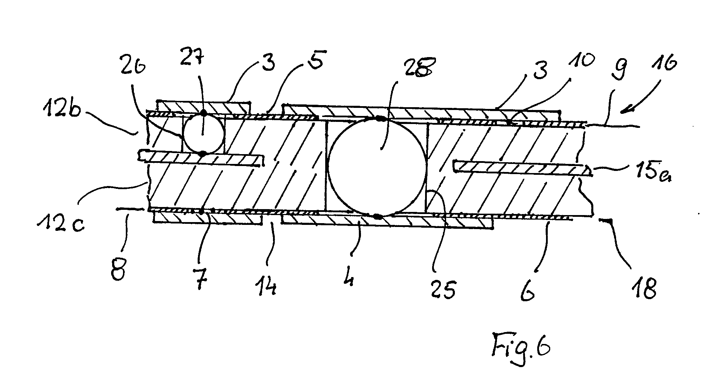

Soll eine Schaltungsplatte erzeugt werden, welche beispielsweise vier Leiterebenen aufweist, dann kann entsprechend Fig. 6 vorgegangen werden. Hierbei werden zwei Leiterplatten 19a, 19b an den mit Drähten zu kontaktierenden Seiten mit einer Heißkleberschicht versehen. An Kontaktpunkten von miteinander zu verbindenden Leiterbahnen sind die Isolierschichten freigestellt. Die beiden Leiterplatten 19a, 19b werden nebeneinandergelegt und zwischen ihnen Drahtverbindungen 20 hergestellt, entsprechend den Drähten 11 bei Fig. 1. Unter Zwischenlage eines Isolierträgers 21 werden dann die beiden Schaltungsplatten 19a, 19b gegeneinandergeklappt, wie dies anhand der Fig. 3 bei den Metallfolien 1, 2 beschrieben wurde. Die Leiterplatten 19a, 19b sind solche, die zuvor, wie anhand der Figuren 1 bis 5 beschrieben, hergestellt wurden.

Es kann jedoch auch gemäß Fig. 7 vorgegangen werden. Neben den Metallfolien 1, 2 sind die Metallfolien 22, 23 vorhanden, welche beidseits der Metallfolie 2 angeordnet sind. Bezüglich der Metallfolien 1, 2 wird vorgegangen, wie anhand der Figuren 1 bis 5 beschrieben. Zusätzliche Drahtverbindungen, wie die Drahtverbindungen 11 zwischen den Metallfolien 1, 2 werden hergestellt zwischen der Metallfolie 2 einerseits und den Metallfolien 22, 23 andererseits. Die Metallfolie 1 wird sodann unter Zwischenlage eines Isolierträgers 12 gegen die Folie 2 geklappt und in vorbeschriebener Weise mit diesem Isolierträger laminiert. Danach werden die Zwischenräume 13, 14 von den Metallfolien 1, 2 abgeätzt. Auf die Oberseite der Schaltungsteilplatte, die aus den Folien 1,2 hergestellt wurde, wird nunmehr unter Zwischenlage eines weiteren Isolierträgers 12 die Folie 22 geklappt, während gegen die Unterseite ebenfalls unter Zwischenlage eines Isolierträgers die Folie 23 geklappt wird. Sodann werden die beiden Folien 22, 23, nachdem sie mit dem jeweiligen Isolierträger laminiert sind, geätzt, wodurch aus diesen Folien 22, 23 die dortigen Leiterbahnen gebildet werden.

Sind die Metallschichten 1, 2 sehr dünne Folien und sind die Isolierschichten 5, 6 ebenfalls dünn, dann können die Metallschichten 1, 2 je auf einem abziehbaren Träger 24 angeordnet sein, wie dies in Fig. 1 und 2 angedeutet ist. Diese Träger 24 werden entfernt, wenn die Metallschichten 1, 2 auf dem Isolierträger 12 aufkaschiert sind, spätestens unmittelbar vor dem Abätzen der Zwischenräume 13, 14.

Eine weitere Ausführungsvariante zeigt die Fig. 6. Der Isolierträger 12 besteht hierbei aus zwei Isolierschichten 12b, 12c mit einer dazwischenliegenden Metallschicht 15a. Bei dieser Metallschicht kann es sich um eine Abschirmschicht oder um Leiterbahnen handeln, die auf eine der Isolierschichten 12b, 12c aufkaschiert sind.

Sollen zusätzliche elektrisch leitende Verbindungen zwischen den Leiterbahnen 3, 4 hergestellt werden, dann wird die Metallschicht 15a an den zu verbindenden Leiterbahnen 3, 4 mit einer Ausnehmung versehen. Nachdem die Schichten 12b, 12c und 15a miteinander verbunden sind, wird eine Ausstanzung 25 angebracht, deren Durchmesser der Dicke des Laminats 12b, 12c, 15a entspricht, in die eine Metallkugel 28 eingesetzt wird. Sodann werden gegen diesen Isolierträger die zuvor mit Drähten 8, 9, 11 bestückten Metallschichten 1, 2 geklappt, wie im Zusammenhang mit den Figuren 1 bis 3 beschrieben und unter Wärmezufuhr auf den Isolierträger aufkaschiert. Die Heißkleberschichten 5, 6 sind im Bereich der Ausstanzung 25 ausgespart. Sodann wird die Kugel 28 an den Stellen, wo sie die Leiterbahnen 3, 4 berührt, mit diesen Leiterbahnen verlötet bzw. verschweißt, was mittels eines Laserstrahls erfolgen kann. Anschließend werden wie vorbeschrieben die Aussparungen 13, 14 zur Bildung der Leiterbahnen 3, 4 abgeätzt.

Soll eine elektrische Verbindung zwischen einer Leiterbahn 3 (oder 4) mit der Metallschicht 15a oder einer von dieser Metallschicht gebildeten Leiterbahn hergestellt werden, dann wird bei der Isolierschicht 12b eine Ausstanzung 26 angebracht und sodann die Metallschicht 15a auf diese Isolierschicht aufkaschiert. Anschließend wird auf die zuvor mit Drähten 9 bzw. 11 bestückte Metallschicht 1 das aus den Schichten 12b, 15a bestehende Laminat mittels der Heißkleberschicht 5 aufkaschiert, wobei zuvor in die Ausstanzung 26 die Kugel 27 eingebracht wurde. Diese Kugel 27 wird dann an den Stellen, wo sie die Metallschichten 1, 15a berührt, mit diesen verschweißt. Sodann wird die Isolierschicht 12c auf die Heißkleberschicht 6 aufgelegt und das aus den Schichten 15a, 12b und 1 bestehende Laminat dagegengeklappt. Die gegeneinandergeklappten Schichten werden in vorbeschriebener Weise miteinander verbunden und anschließend werden die Zwischenräume 13, 14 abgeätzt.

## Ansprüche

1. Verfahren zur Herstellung elektrischer Verbindungen zwischen flachen, elektrischen Leiterbahnen (3), welche auf einer Isolierschicht (5) angeordnet sind und welche aus einer durchgehenden Metallschicht (1) durch Entfernen der Zwischenräume (13) zwischen den Leiterbahnen (3) hergestellt werden und wobei die Verbindungen durch erste isolierte Drähte (9) hergestellt werden, die an Kontaktpunkten (10) an den miteinander zu verbindenden Leiterbahnen (3) mit diesen verbunden sind, dadurch **gekennzeichnet**, daß die Kontaktpunkte (10) an der der Isolierschicht (5) zugewandten Seite der Leiterbahnen (3) vorgesehen werden, die ersten Drähte (9) auf dieser Seite an den Kontaktpunkten (10) mit der durchgehenden Metallschicht (1) verbunden und auf der Ebene der Metallschicht (1) verlaufend in die Isolierschicht (5) eingebettet werden und anschließend von der Metallschicht (1) die Zwischenräume (13) zur Bildung der Leiterbahnen (3) entfernt werden.

2. Verfahren zur Herstellung elektrisch leitender Verbindungen zwischen ersten und zweiten flachen elektrischen Leiterbahnen (3, 4), zwischen denen mindestens eine Isolierschicht (5, 6) angeordnet ist und welche aus zwei durchgehenden Metallschichten (1, 2) durch Entfernen der Zwischenräume (13, 14) zwischen den Leiterbahnen (3, 4) hergestellt werden und wobei die Verbindungen durch zweite isolierte Drähte (11) hergestellt werden, die an ersten Kontaktpunkten (10) der ersten Leiterbahnen (3) und an zweiten Kontaktpunkten (7) der damit zu verbindenden zweiten Leiterbahnen (4) mit diesen Leiterbahnen (3, 4) verbunden sind, dadurch **gekennzeichnet**, daß die Kontaktpunkte (7, 10) an den der Isolierschicht (5, 6) zugewandten Seite der Leitbahnen (3, 4) vorgesehen werden, bei nebeneinanderliegenden durchgehenden Metallschichten (1, 2) die zweiten Drähte (11) auf diesen Seiten an den ersten und zweiten Kontaktpunkten (7, 10) mit den beiden Metallschichten (1, 2) verbunden werden, sodann die beiden Metallschichten (1, 2) mit diesen Seiten gegeneinander geklappt werden und im gegeneinandergeklappten Zustand mindestens die auf den Ebenen der Metallschichten (1, 2) verlaufenden Teile der zweiten Drähte (11) in die Isolierschicht (5, 6) eingebettet sind und anschließend von den Metallschichten (1, 2) die Zwischenräume (13, 14) zur Bildung der Leiterbahnen (3, 4) entfernt werden.

3. Verfahren nach Anspruch 2, dadurch **gekennzeichnet**, daß bei nebeneinanderliegenden Metallschichten (1, 2) erste Drähte (9) mit ersten Kontaktpunkten (10), die zweiten Drähte (11) mit ersten und zweiten Kontaktpunkten (7, 10) und gegebenenfalls dritte Drähte (8) mit zweiten Kontaktpunkten (10) verbunden werden, bevor die beiden Metallschichten (1, 2) gegeneinander geklappt werden, wobei im gegeneinandergeklappten Zustand auch die auf den Ebenen der Metallschichten (1, 2) verlaufenden ersten und gegebenenfalls dritten Drähte (9, 8) in die Isolierschicht (5, 6) eingebettet sind.

4. Verfahren nach einem der Ansprüche 1 bis 3, dadurch **gekennzeichnet**, daß auf jede Metallschicht (1, 2) eine Isolierschicht (5, 6) aufgebracht wird, bei der die Kontaktpunkte (7, 10) freigelassen sind, die Drähte (8, 9, 11) mit den Kontaktpunkten (7, 10) verbunden und die auf der Ebene einer Metallschicht (1, 2) verlaufenden Drähte (8, 9, 11) bzw. Drahtteile in die Isolierschicht (5, 6) eingebettet werden, sodann die Isolierschicht (5, 6) mit einem Isolierträger (12) verbunden wird und die Entfernung der Zwischenräume (13, 14) zur Bildung der Leiterbahnen (3, 4) erfolgt, wenn die Isolierschicht (5, 6) mit dem Isolierträger (12) verbunden ist.

5. Verfahren nach Anspruch 4, dadurch **gekennzeichnet**, daß die beiden Metallschichten (1, 2) unter Zwischenlage des Isolierträgers (12) gegeneinander geklappt werden.

6. Verfahren nach einem der Ansprüche 1 bis 5, dadurch **gekennzeichnet**, daß als Isolierschicht (5, 6) jeweils eine Schmelzkleberschicht verwendet wird, in welche die auf der Ebene einer Metallschicht (1, 2) verlaufenden Drähte (8, 9, 11) bzw.

Drahtteile durch Wärmeeinwirkung eingebettet werden, wenn der jeweilige Draht (8, 9, 11) von einem zum anderen Kontaktpunkt (7, 10) geführt wird.

7. Verfahren nach Anspruch 6, dadurch **gekennzeichnet**, daß die Verbindung zwischen Isolierschicht bzw. Isolierschichten (5, 6) und dem Isolierträger (12) durch Wärmeeinwirkung erfolgt, bevor die Zwischenräume (13, 14) zur Bildung der Leiterbahnen (3, 4) entfernt werden.

8. Verfahren nach einem der Ansprüche 4 bis 7, dadurch **gekennzeichnet**, daß der Isolierträger (12a) aus einem nur zum Teil ausgehärteten Kunststoff besteht, in welchen die zweiten Drähte (11) eindringen und der ausgehärtet wird, nachdem die beiden Metallschichten (1, 2) gegeneinander geklappt sind und bevor die Zwischenräume (13, 14) zur Bildung der Leiterbahnen (3, 4) entfernt werden.

9. Verfahren nach einem der Ansprüche 1 bis 8, dadurch **gekennzeichnet**, daß die Metallschicht (1, 2) auf einem Träger (24) angeordnet ist, der sich auf der den Kontaktpunkten (7, 10) gegenüberliegenden Seite der Metallschicht befindet und der vor dem Entfernen der Zwischenräume (13, 14) zur Bildung der Leiterbahnen (3, 4) entfernt wird.

10. Verfahren nach einem der Ansprüche 5 bis 9, dadurch **gekennzeichnet**, daß als Isolierträger (12) ein aus zwei Isolierschichten (12b, 12c) und einer dazwischenliegenden Metallschicht (15) bestehender Träger (12) verwendet wird.

11. Verfahren nach einem der Ansprüche 5 bis 10, dadurch **gekennzeichnet**, daß der Isolierträger (12) mit Ausstanzungen (25, 26) versehen wird, in welche vor dem Gegeneinanderklappen der Metallschichten (1, 2) Metallkugeln (27, 28) eingesetzt werden, die mit den Metallschichten (1, 2) bzw. der Metallschicht (15) verschweißt werden.

12. Schaltungsplatte bestehend aus einer Isolierschicht (12) und darauf angeordneten flachen elektrischen Leiterbahnen (3), dadurch **gekennzeichnet**, daß miteinander elektrisch zu verbindende Leiterbahnen (3) durch elektrisch isolierte Drähte (9) miteinander verbunden sind, die auf der der Isolierschicht (12) zugewandten Seite der Leiterbahnen (3) auf deren Ebene verlaufen und in die Isolierschicht (12) eingebettet sind.

13. Schaltungsplatte bestehend aus einer Isolierschicht (12) mit beidseits darauf angeordneten flachen Leiterbahnen (3, 4), dadurch **gekennzeichnet**, daß miteinander elektrisch zu verbindende Leiterbahnen (3, 4) durch elektrisch isolierte Drähte (8, 9, 11) miteinander verbunden sind, die auf den der Isolierschicht (12) zugewandten Seiten der Leiterbahnen (3, 4) auf deren Ebenen verlaufen und die in die Isolierschicht (12) eingebettet sind, wobei die von einer Leiterbahnebene (16) zur anderen Leiterbahnebene (18) verlaufenden Drahtteile (11) an einer Seite der Schaltungsplatte die Isolierschicht (12) überbrückend verlaufen.

14. Schaltungsplatte nach Anspruch 13, dadurch **gekennzeichnet**, daß die Isolierschicht (12) Bohrungen (25, 26) aufweist, in welche Kugeln (27, 28) eingesetzt sind, die mit Leiterbahnen (3, 4) bzw. mit einer in der Isolierschicht verlaufenden Abschirmschicht (15) verschweißt sind.

Fig.1

Fig.2

Fig. 3

Fig 4

EP 0 312 631 A1

Fig 5

Fig 7

Fig 8

Fig.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | FR-A-2 140 666 (AMP INC.)<br>* Ansprüche 1,3-6,11, Figuren 5-7;<br>Seite 4, Zeile 31 - Seite 5, Zeile 33 *<br>--- | 1,2,11 | H 05 K 3/36<br>H 05 K 7/06<br>H 05 K 1/18 |
| A | DE-A-3 015 100 (R. CASTANET)<br>* Seite 13, Zeile 9 - Seite 14, Zeile 13; Figuren 1-5 *<br>--- | 1,2 | |
| A | FR-A-1 567 363 (PHILPS)<br>* Seite 2, Zeile 8 - Seite 3, Zeile 9 *<br>----- | 1,2 | |

|  |  |
|---|---|
| | RECHERCHIERTE SACHGEBIETE (Int. Cl.4) |
| | H 05 K 3/00<br>H 05 K 1/00<br>H 05 K 7/00 |

Der vorliegende Recherchenbericht wurde für alle Patentansprüche erstellt

| Recherchenort | Abschlußdatum der Recherche | Prüfer |
|---|---|---|
| BERLIN | 06-06-1988 | CLOSA D. |